# EUROPEAN PATENT APPLICATION

(11) **EP 4 773 175 A1**
(43) Date of publication of application: **08.07.2026**
(21) Application number: 24860254.2
(22) Date of filing: 12.08.2024
(51) Int. Cl.: H01L 21/67

(54) **HIGH-PRESSURE SUBSTRATE PROCESSING APPARATUS**

(30) Priority: 01.09.2023 KR 20230116413
(71) Applicant: HPSP Co., Ltd., Hwaseong-si, Gyeonggi-do 18449 (KR)
(72) Inventor: AHN, Jae Beom, Hwaseong-si, Gyeonggi-do 18449 (KR); LIM, Kunyoung, Hwaseong-si, Gyeonggi-do 18449 (KR); MIN, Bin Hong, Hwaseong-si, Gyeonggi-do 18449 (KR)
(74) Representative: von Bülow & Tamada
(86) International application number: PCT/KR2024/012012
(87) International publication number: WO 2025/048333

(57) **Abstract**

This high-pressure substrate processing apparatus is disclosed. The high-pressure substrate processing apparatus includes an inner chamber, an outer chamber, and a fastening module. The inner chamber is formed so as to accommodate a substrate to be processed and a reaction gas supplied at a first pressure higher than atmospheric pressure. The outer chamber includes: an outer housing accommodating the inner chamber; and an outer door formed to be movable between a closed state in which the outer door is in contact with the outer housing and an open state in which the outer door is spaced apart from the outer housing. The outer chamber is formed to accommodate a protective gas supplied at a second pressure that is set in relation to the first pressure. The fastening module includes: a support protrusion installed in the outer housing; a rotary member disposed to be rotatable with respect to the outer door; and an engaging protrusion extending from the rotary member and formed to be placed on the support protrusion. The outer door includes an upper plate in contact with the outer housing in the closed state.

## Description

### [Technical Field]

The present disclosure relates to a processing apparatus used to process a substrate in a high-pressure environment.

### [Background Art]

Generally, during the semiconductor device manufacturing process, various processes are performed on a semiconductor substrate. Examples of the processing include oxidation, nitridation, ion implantation, deposition processes, etc. A hydrogen or deuterium heat treatment process is also used to improve the interface characteristics of the semiconductor device.

The gas used to process the substrate is supplied to the chamber at high-pressure and acts on the semiconductor substrate. To maintain the chamber at high-pressure, the housing of the chamber should be securely closed by a door.

When a closed state of the chamber is loosened by high-pressure gas, a gap may be formed between the housing and the door. The gap may become a passage through which the gas within the chamber leaks out.

### [Disclosure]

### [Technical Problem]

An object of the present disclosure is to provide a high-pressure substrate processing apparatus capable of firmly maintaining a closed state between a housing and a door even under high-pressure within a chamber.

Another object of the present disclosure is to provide a high-pressure substrate processing apparatus capable of minimizing force required to fasten between a housing and a door.

### [Technical Solution]

To achieve the above problem, according to an aspect of the present disclosure, a high-pressure substrate processing apparatus includes an inner chamber formed to accommodate a substrate to be processed and a reaction gas supplied at a first pressure higher than atmospheric pressure, an outer chamber including an outer housing accommodating the inner chamber and an outer door formed to be movable between a closed state in which the outer door is in contact with the outer housing and an open state in which the outer door is spaced apart from the outer housing, and formed to accommodate a protective gas supplied at a second pressure that is set in relation to the first pressure, and a fastening module including a support protrusion installed in the outer housing, a rotary member disposed to be rotatable with respect to the outer door, and an engaging protrusion extending from the rotary member and formed to be disposed on the support protrusion, in which the outer door includes an upper plate in contact with the outer housing in the closed state.

The engaging protrusion may be disposed to be supported by the support protrusion as the engaging protrusion rotates in the closed state.

The rotary member may be disposed below the upper plate.

The support protrusion may be installed to protrude outward from the outer housing, and the engaging protrusion may be bent to surround the support protrusion.

The outer door may further include a lower plate disposed at a different level from the upper plate, and the rotary member may be disposed between the upper plate and the lower plate.

The outer door may further include a spacer disposed between the upper plate and the lower plate, and the rotary member may include a rotary ring having a hollow portion formed to accommodate the spacer.

The outer door may further include a sealing member disposed between the upper plate and the outer housing in the closed state, and the engaging protrusion may be formed to rotate independently of contact between the upper plate, the sealing member, and the outer housing.

The fastening module may further include a drive unit configured to rotate the rotary member so as to rotate the engaging protrusion.

The drive unit may include a driven gear formed on the rotary member, a drive gear meshing with the driven gear, and a motor rotating the drive gear.

The outer door may further include a shaft protrusion protruding downward from the upper plate, and the rotary member may include an accommodating groove that rotatably accommodates the shaft protrusion.

The rotary member may include a base portion having the accommodating groove formed therein, and a protruding portion formed to protrude downward from the base portion, the fastening module may further include a drive unit formed to rotate the rotary member, and the drive unit may include a driven gear formed on an outer surface of the protruding portion, a drive gear meshing with the driven gear, and a motor rotating the drive gear.

According to another aspect of the present disclosure, a high-pressure substrate processing apparatus includes a chamber including a housing formed to accommodate a substrate to be processed and a process gas supplied at a pressure higher than atmospheric pressure, and a door formed to move between a closed state in which the housing is closed and an open state in which the housing is open, and a fastening module including a support protrusion installed in the housing, a rotary member disposed to be rotatable with respect to the door, and an engaging protrusion extending from the rotary member and formed to be disposed on the support protrusion, in which the door includes an upper plate that contacts the housing in the closed state, and the rotary member is disposed below the upper plate.

The engaging protrusion may be disposed to be supported by the support protrusion as the engaging protrusion rotates in the closed state.

The engaging protrusion may include an engaging surface that faces the support protrusion and is disposed at a higher level than the door.

The process gas may include a reaction gas containing an active gas and a protective gas containing an inert gas, and the housing may include an inner housing formed to accommodate the substrate to be processed and the reaction gas, and an outer housing accommodating the inner housing and coupled to the inner housing to form a closed space that accommodates the protective gas together with the inner housing, and the door may be formed to close the inner housing.

### [Advantageous Effects]

According to a high-pressure substrate processing apparatus of the present disclosure, configured as described above, as a fastening module that fastens a housing and a door is configured such that an engaging protrusion moves with respect to a support protrusion installed in the housing and is disposed on the support protrusion, the engagement between the engaging protrusion and the support protrusion can firmly maintain the closed state between the housing and the door even under the high-pressure within the chamber.

In addition, since the engaging protrusion moves independently of the door, to fasten the housing and the door, only the engaging protrusion, excluding the door, needs to move. As a result, it is possible to minimize the force required to fasten between the housing and the door.

Furthermore, since the door remains fixed with respect to the housing during the movement of the engaging protrusion, the wear due to relative rotation between the door and the housing does not occur.

### [BRIEF DESCRIPTION OF THE DRAWINGS]

FIG. 1 is a conceptual diagram of a high-pressure substrate processing apparatus according to an embodiment of the present disclosure.
FIG. 2 is an exploded perspective view illustrating an open state of the high-pressure substrate processing apparatus of FIG. 1.
FIG. 3 is a cross-sectional view illustrating a closed state of the high-pressure substrate processing apparatus of FIG. 2.
FIG. 4 is a cutaway perspective view for describing a configuration driving a rotary member of FIG. 3.
FIG. 5 is a flowchart for describing a state transition process of the high-pressure substrate processing apparatus of FIG. 2.
FIG. 6 is a cross-sectional view illustrating a closed state of a high-pressure substrate processing apparatus according to another embodiment of the present disclosure.

### [Best Mode]

Hereinafter, preferred embodiments of the present disclosure will be described in detail with reference to the accompanying drawings.

The present disclosure is not limited to embodiments set forth herein, but may be modified in various different forms. However, the present embodiment is provided solely to ensure that the present disclosure is complete and to fully inform those skilled in the art of the scope of the invention. It should be understood that the accompanying drawings are provided only in order to allow embodiments disclosed in the present specification to be easily understood, and are not intended to limit the teachings disclosed in the present specification. All the modifications, equivalents, and substitutions may be made without departing from the teachings and the scope of the present disclosure.

It should be understood that the accompanying drawings are provided only in order to allow embodiments disclosed in the present specification to be easily understood, and the teachings disclosed in the present specification are not limited by the accompanying drawings, but include all the modifications, equivalents, and substitutions included in the teachings and the scope of the present disclosure. In the drawings, components may be exaggerated in size or thickness for ease of understanding, but this should not be construed as limiting the scope of protection of the present disclosure.

Terms used in the present specification are used only in order to describe specific implementation examples or embodiments rather than limiting the present disclosure. Singular expressions are intended to include plural expressions unless the context clearly indicates otherwise. In the specification, terms such as "~include," or "comprise" are intended to specify the presence of stated features, numbers, steps, operations, components, parts, or combinations thereof described in the specification. That is, it should be understood that terms such as "~include" or "~comprise" in the specification do not preclude the existence or addition possibility of one or more other features or numbers, steps, operations, components, parts, or combinations thereof.

Terms including ordinal numbers such as "first," "second," etc., may be used to describe various components, but the components are not to be construed as being limited to the terms. The terms are used to distinguish one component from another component.

It is to be understood that when one element is referred to as being "connected to" or "coupled to" another element, it may be connected directly to or coupled directly to another element or be connected to or coupled to another element, having the other element intervening therebetween. On the other hand, it should be understood that when one element is referred to as being "connected directly to" or "coupled directly to" another element, it may be connected to or coupled to another element without the other element interposed therebetween.

When a component is referred to as being "above" or "below" another component, it should be understood that it is not only positioned directly above that other component, but also that other components may be present in between.

Unless indicated otherwise, it is to be understood that all the terms used in the specification including technical and scientific terms have the same meaning as those that are generally understood by those who are skilled in the art. Terms generally used and defined by a dictionary should be interpreted as having the same meanings as meanings within a context of the related art and should not be interpreted as having ideal or excessively formal meanings unless being clearly defined otherwise in the present specification.

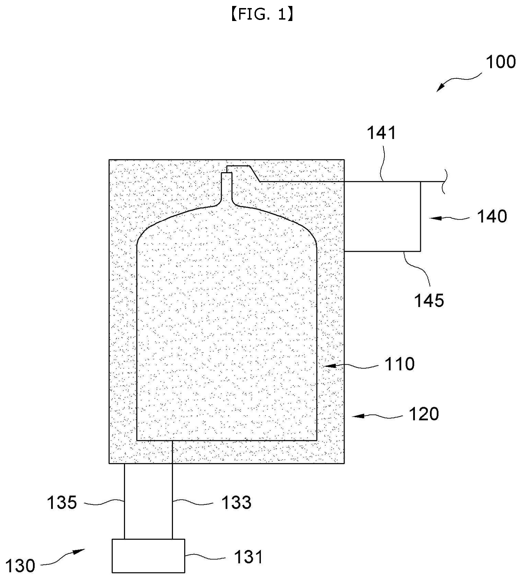

FIG. 1 is a conceptual diagram of a high-pressure substrate processing apparatus according to one embodiment of the present disclosure.

Referring to this drawing, a high-pressure substrate processing apparatus 100 may include an inner chamber 110, an outer chamber 120, a gas supply module 130, and an exhaust module 140.

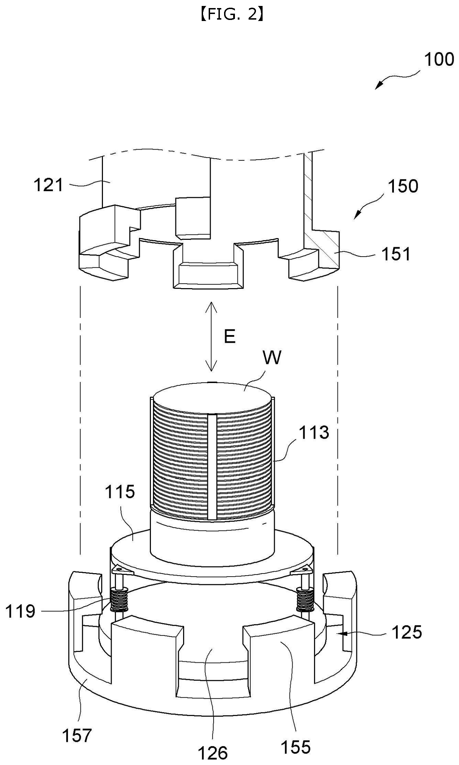

The inner chamber 110 forms a processing space that accommodates a substrate for processing. The inner chamber 110 may be manufactured from a non-metallic material, such as quartz, to reduce contamination in a high-temperature and high-pressure operating environment. Depending on the operation of a heater (not illustrated) disposed outside the inner chamber 110, the temperature of the inner chamber 110 may reach hundreds of to a thousand °C. The substrate may be, for example, a semiconductor substrate W (see FIG. 2) loaded onto a holder. The holder may be a wafer boat 113 (see FIG. 2) capable of stacking a substrate W to be processed in multiple layers. The substrate is not limited to the wafer, and any other base structures for forming a circuit may also be used. For example, the substrate may also include glass for display manufacturing.

The outer chamber 120 forms an inner space in which the inner chamber 110 is accommodated. The outer chamber 120 is disposed outside the inner chamber 110. Unlike the inner chamber 110, the outer chamber 120 is free from concerns about contamination of the object and may therefore be made of metal.

The gas supply module 130 is configured to supply gas to the inner chamber 110 and the outer chamber 120. The gas supply module 130 has a gas supply device 131 that serves as a gas source. The gas supply device 131 may selectively supply, to the inner chamber 110, reaction gases, such as hydrogen gas (H₂), deuterium gas (D₂), fluorine gas (F₂), ammonia gas (NH₃), chlorine gas (Cl₂), and nitrogen gas (N₂) as a reaction gas for heat treatment. The gas supply device 131 may provide, to the outer chamber 120, a protective gas, such as nitrogen gas or argon gas (Ar) that is the inert gas. The reaction gas and the protective gas may be simply referred to as process gases. The process gases are supplied to the inner chamber 110 or outer chamber 120 via a reaction gas line 133 or a protective gas line 135, respectively. The protective gas supplied to the outer chamber 120 is specifically supplied to a space (protection space) between the outer chamber 120 and the inner chamber 110.

The process gas may be supplied at a pressure (i.e., high-pressure) higher than atmospheric pressure, for example, at a pressure ranging from several atmospheres to several tens of atmospheres. When the pressure of the reaction gas is a first pressure and the pressure of the protective gas is a second pressure, these pressures may be maintained at a set relationship. For example, the second pressure may be set to be substantially equal to or slightly higher than the first pressure. Such a pressure relationship provides the advantage of preventing the reaction gas from leaking from the inner chamber 110. The second pressure may be slightly lower than the first pressure, and such a pressure relationship may prevent the inner chamber 110 from being damaged even under high-pressure.

The exhaust module 140 is configured to exhaust the process gas. In order to exhaust the reaction gas from the inner chamber 110, an exhaust pipe 141 is connected to an upper portion of the inner chamber 110. Similarly, to exhaust the protective gas from the outer chamber 120, an exhaust pipe 145 communicating with the outer chamber 120 may be provided. Since these exhaust pipes 141 and 145 are integrated into one, the reaction gas is diluted by the protective gas during the exhaust process, thereby lowering its concentration.

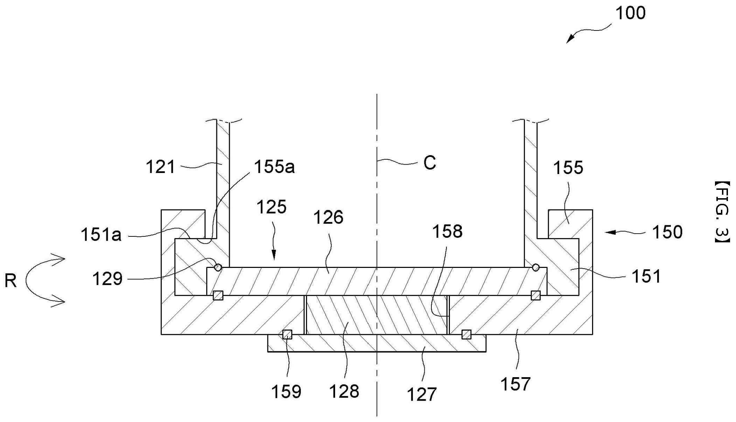

The fastening structure of the outer chamber 120 will be described with reference to FIGS. 2 and 3. FIG. 2 is an exploded perspective view illustrating an open state of the high-pressure substrate processing apparatus of FIG. 1, and FIG. 3 is a cross-sectional view illustrating a closed state of the high-pressure substrate processing apparatus of FIG. 2.

Referring to these drawings, the inner chamber 110 includes the inner housing (not illustrated) and the inner door 115. The inner housing forms the processing space that accommodates the substrate W to be processed, and its lower portion may have an open form. The inner door 115 has a form in which the open lower portion of the inner housing is closed. The inner door 115 may have a trough shape in which it is open downward overall.

As the inner door 115 is lowered, the processing space is open (open state, see FIG. 2). In the open state, the substrate to be processed is unloaded from the boat 113, and a new substrate to be processed is loaded onto the boat 113. As the inner door 115 is raised, the processing space is closed (closed state, see FIG. 3). In the closed state, more specifically, in a fastened state to be described later among the closed states, processing on the substrate W to be processed, for example, heat treatment, deposition, or the like, is performed.

The outer chamber 120 also includes an outer housing 121 and an outer door 125. The outer housing 121 is sized to accommodate the inner chamber 110. The inner housing 111 is mounted on the outer housing 121. The outer door 125 may also open and close the outer housing 121 as the outer door 125 moves. The outer door 125 is connected to the inner door 115 by a support member 119. The support member 119 has a spring support structure that elastically is expanded and contracted along an opening/closing direction E. The support member 119 is not limited to a spring support structure, and may be formed of another hydraulic or pneumatic support structure, or a heat-resistant elastic material, etc. The opening/closing direction E is a direction in which the outer door 125 moves to transition between the closed state and the open state. When the outer housing 121 is erected, the opening/closing direction E may be substantially the same as the height direction or vertical direction. During the transition from the open state to the closed state, the support member 119 allows the outer door 125 to move toward the inner door 115.

The outer door 125 opens and closes the outer housing 121 while moving up and down together with the inner door 115. Unlike the above description, the inner door 115 and the outer door 125 are not connected to each other and may move to be open and closed independently.

The high-pressure substrate processing apparatus 100 may further include a fastening module 150 for fastening the outer housing 121 and the outer door 125 in the closed state to transition the outer housing and the outer door 121 and 125 to the fastened state. Since the inner door 115 is supported on the outer door 125 by the support member 119, the fastening module 150 is configured such that the inner door 115 is also in close contact with the inner housing. The fastening module 150 maintains the protective gas at the second pressure within the outer chamber 120. The fastening module 150 also exerts a fastening force to maintain the reaction gas at the first pressure within the inner chamber 110.

Specifically, the fastening module 150 may include a support protrusion 151 and an engaging protrusion 155.

The support protrusion 151 is a protrusion installed on the outer housing 121. As in the present embodiment, the support protrusion 151 may be installed so as to be exposed on an outer peripheral surface of the outer housing 121. The outer peripheral surface may be an outer side surface of the outer chamber 120. The support protrusion 151 may be formed to protrude from the outer side surface or may be engraved on the outer side surface. In the latter case, a first groove along an elevation direction E of the outer housing 121 and a second groove generally perpendicular thereto may be formed. The support protrusion is defined by the first and second grooves. A support surface 151a, which will be described later, may be a wall surface that defines the second groove and is disposed on a lower portion of the second groove. The plurality of support protrusions 151 may be arranged along a circumferential direction of the outer peripheral surface. The plurality of support protrusions 151 may be disposed on the same level or plane along the elevation direction E.

The engaging protrusion 155 is a protrusion connected to the outer door 125. The engaging protrusion 155 is sized to pass between a pair of adjacent support protrusions 151 when the outer door 125 moves in the elevation direction E. The engaging protrusion 155 may be provided in multiple numbers, like the support protrusion 151.

The engaging protrusion 155 may move while being connected to the outer door 125. For example, the engaging protrusion 155 may be rotatably installed with respect to the outer door 125. In an alternative embodiment, the engaging protrusion 155 may rotate together with the outer door 125.

When the engaging protrusion 155 is disposed on the support protrusion 151 depending on the movement, specifically, rotation, the engaging protrusion 155 may be supported by the support protrusion 151 (fastened state). In the fastened state, an engaging surface 155a, which is a bottom surface of the engaging protrusion 155, faces the support surface 151a, which is a top surface of the support protrusion 151, and is also supported by the support surface 151a. The engaging surface 155a is disposed at a higher level than the outer door 125. In this fastened state, the outer door 125 may remain firmly fastened to the outer housing 121 even under the high-pressure of the process gas.

When the plurality of engaging protrusions 155 are provided, the plurality of engaging protrusions 155 may rotate individually. On the other hand, the engaging protrusion 155 may rotate together with a rotary member 157 while integrated with the rotary member 157. The engaging protrusion 155 may extend outward from an outer peripheral surface of the rotary member 157. Specifically, the engaging protrusion 155 may have a bent and extended shape to surround the support protrusion 151 in cross-section. The engaging protrusion 155 may surround the support protrusion 151 from the outside of the outer housing 121. The rotary member 157 may be disposed to rotate in a rotational direction R (about a rotational axis C set along the elevation direction E).

The rotary member 157 may be rotatably coupled to the outer door 125. The outer door 125 may have an upper plate 126 and a lower plate 127. The rotary member 157 may be positioned between the upper plate 126 and the lower plate 127. A bearing 159 may be disposed between each of the upper plate 126 and the lower plate 127 and the rotary member 157. A thrust bearing may be used as the bearing 159.

The upper plate 126 is disposed to be in contact with the outer housing 121 in the closed state. The upper plate 126 and the lower plate 127 may be connected by a spacer 128, which is an additional component of the outer door 125. The lower plate 127 may be disposed at a different level from the upper plate 126. The spacer 128 may have a smaller diameter or width than the upper plate 126 and/or the lower plate 127. The spacer 128 may be formed as a separate member from the upper plate 126 and the lower plate 127, or may form a single member with one or both of the upper plate 126 and the lower plate 127. When the upper plate 126, the lower plate 127, and the spacer 128 form a single member, the rotary member 157 may be formed by manufacturing a plurality of pieces and subsequently joining the plurality of pieces together while each piece is inserted in the space between the upper plate 126 and the lower plate 127.

The rotary member 157 may be disposed substantially parallel to the outer door 125 while the spacer 128 is inserted into a hollow portion 158 of the rotary member 157. The rotary member 157 in this form may be referred to as a rotary ring.

While the rotary ring 157 rotates in the closed state, the outer door 125 may not be linked to the rotation of the rotary ring 157. In other words, while the upper plate 126 maintains the contact with the outer housing 121 via a sealing member 129, the rotary ring 157 may rotate independently of the contact state. The sealing member 129 may be an O-ring installed on an upper surface of the upper plate 126.

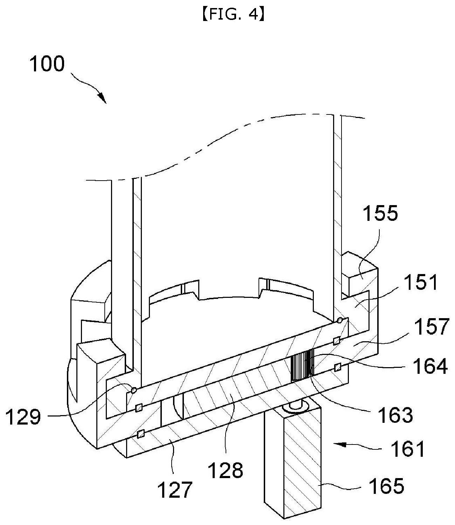

The configuration for rotating the rotary ring 157 will be described with reference to FIG. 4. FIG. 4 is a cutaway perspective view for describing a configuration driving a rotary ring of FIG. 3.

Referring further to this drawing, the rotary ring 157 may rotate by a drive unit 161.

The drive unit 161 may have a driven gear 163, a drive gear 164, and a motor 165. The driven gear 163 may be formed on an inner peripheral surface of the rotary ring 157. The drive gear 164 may be a gear that meshes with the driven gear 163. The drive gear 164 may be disposed between the rotary ring 157 and the spacer 128.

According to this configuration, the rotational power of the motor 165 is transmitted to the drive gear 164. A transmission shaft connecting an output shaft of the motor 165 and the drive gear 164 may be disposed to penetrate through the lower plate 127. As the drive gear 164 rotates, the driven gear 163 meshing with the drive gear 164 also rotates. As the rotary ring 157 rotates around the rotational axis C (FIG. 3) according to the rotation of the driven gear 163, the engaging protrusion 155 also rotates along the rotational direction R (FIG. 3). The engaging protrusion 155 may move onto the support protrusion 151 or move to a position misaligned from the support protrusion 151, depending on its rotation. During the rotation of the engaging protrusion 155, the outer door 125 does not rotate together with the engaging protrusion 155. The torque required to be output from the motor 165 may be sufficient at a level to rotate the engaging protrusion 155, excluding the outer door 125.

While the drive unit 161 has been described as including the gears 163 and 164 and the motor 165, the present disclosure is not limited thereto. The drive unit may also be configured using other actuators, such as a cylinder.

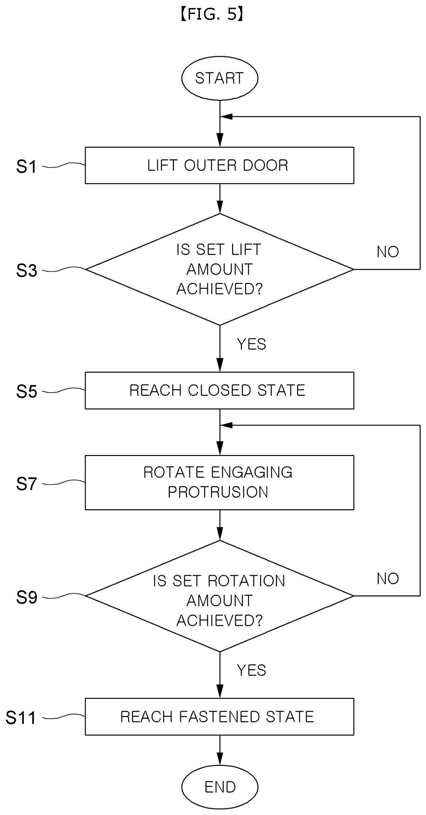

The process from the open state to the fastened state will be further described with reference to FIG. 5. FIG. 5 is a flowchart for describing a state transition process of the high-pressure substrate processing apparatus of FIG. 2.

Referring further to this drawing, in the open state (see FIG. 2), the outer door 125 may be lifted toward the outer housing 121 (S1). The outer door 125 may be lifted by a lifter (not illustrated) operating in the opening/closing direction E.

A control module (not illustrated) may determine whether a lift level of the outer door 125 has reached a set lift amount (S3). The determination may be made based on the lift amount of the lifter. Alternatively, the determination may be made based on the measured level of the outer door 125.

During the lifting of the outer door 125, the engaging protrusion 155 passes between a pair of adjacent support protrusions 151. This causes the engaging surface 155a to be disposed slightly higher than the support surface 151a.

When the set lift amount is achieved, the outer door 125 may reach the closed state (S5). In the closed state, the upper plate 126 of the outer door 125 comes into contact with the outer housing 121. The sealing member 129 seals a gap between the upper plate 126 and the outer housing 121. The engaging surface 155a is misaligned with the support surface 151a and is not supported by the support surface 151a.

In the closed state, the engaging protrusion 155 may rotate (S7). Specifically, according to the operation of the drive unit 161, the rotary ring 157 rotates around the rotational axis C (FIG. 3), and the engaging protrusion 155 connected to the rotary ring 157 also rotates.

The control module may determine whether the rotational degree of the rotary ring 157 has achieved the set rotation amount (S9). This determination may be made based on the operating time of the drive unit 161. Alternatively, the determination may be made based on the measured position/angle of the engaging protrusion 155.

When the set rotation amount is achieved, the outer door 125 may be considered to have reached the fastened state (S11). In the fastened state, the engaging protrusion 155 is disposed corresponding to the support protrusion 151. The engaging surface 155a is supported by the support surface 151a.

The process of transitioning from the fastened state to the open state via the closed state may be performed by reversing the above-described steps.

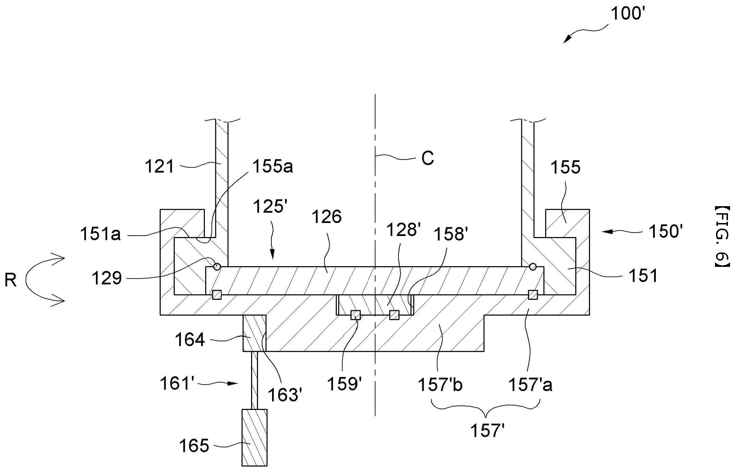

Another form of high-pressure substrate processing apparatus 100' will be described with reference to FIG. 6. FIG. 6 is a cross-sectional view illustrating a closed state of a high-pressure substrate processing apparatus according to another embodiment of the present disclosure.

Referring to this drawing, the high-pressure substrate processing apparatus 100' is substantially the same as the high-pressure substrate processing apparatus 100 according to the foregoing embodiment, but differs in an outer door 125', a rotary member 157', and a drive unit 161'.

The rotary member 157' may have a generally disk shape rather than a ring shape. The rotary member 157' may specifically have a base portion 157'a and a protruding portion 157'b. When the base portion 157'a is disposed below the upper plate 126, the protruding portion 157'b is a portion protruding downward from the base portion 157'a.

An accommodating groove 158' may be recessed in the base portion 157'a. Corresponding to the accommodating groove 158', the outer door 125' may have a shaft protrusion 128' protruding downward from the upper plate 126. By rotatably accommodating the shaft protrusion 128' in the accommodating groove 158', the horizontal alignment between the upper plate 126 and the rotary member 157' may be maintained. For the smooth rotation of the rotary member 157' {specifically, the protruding portion 157'b} with respect to the shaft protrusion 128', a bearing 159' may be disposed between the shaft protrusion 128' and the protruding portion 157'b.

Depending on the structural relationship between the base portion 157'a and the protruding portion 157'b, the drive unit 161' may also vary. Specifically, a driven gear 163', which is a component of the drive unit 161', may be formed on an outer peripheral surface of the protruding portion 157'b. The drive gear 164 connected to the motor 165 meshes with the driven gear 163'. The drive gear 164 may not penetrate the outer door 125' or the rotary member 157', but may be disposed outside of the outer door 125' and the rotary member 157'. Although the present specification has been described by taking, as an example, a high-pressure substrate processing apparatus 100 having a dual chamber, the present disclosure is not limited thereto. A processing apparatus having a single chamber is also within the scope of the present disclosure. The single chamber includes one housing and one door. The wafer substrate is disposed within the chamber, and the gas for processing the wafer substrate is supplied. The fastening module 150 and 150' is also applied to such a single chamber. The fastening module 150 and 150' ensures that the door is firmly fastened to the housing despite the pressure of the gas.

The fastening modules 150 and 150' may also be applied to a semi-dual chamber, which is an intermediate form between the dual chamber and the single chamber. The semi-dual chamber may have two housings (the inner housing and the outer housing) and one door. The two housings may correspond to the inner housing and the outer housing 121 of the above-described embodiment. The two housings may be connected by their own shapes or by intervening with a separate member to form a closed space (corresponding to the protection space). As in the embodiment described above, the substrate may be arranged in the processing space of the inner housing, the reaction gas may be injected, and the protective gas may be injected into the closed space. Unlike the above-described embodiments, the door is not protected by the protective gas.

The door may correspond to the outer door 125 of the above-described embodiments. The door may open/close the inner housing (and the outer housing). For the operation between the outer housing and the door, the fastening modules 150 and 150' as described in the foregoing embodiment are applied.

While the present specification exemplifies a batch-type processing apparatus, the present disclosure is not limited thereto. The present disclosure may also be applied to a single wafer type processing apparatus.

### [Industrial Applicability]

The present disclosure has industrial applicability in the field of manufacturing a high-pressure substrate processing apparatus.

## Claims

1. A high-pressure substrate processing apparatus, comprising:
an inner chamber formed to accommodate a substrate to be processed and a reaction gas supplied at a first pressure higher than atmospheric pressure;
an outer chamber including an outer housing accommodating the inner chamber and an outer door formed to be movable between a closed state in which the outer door is in contact with the outer housing and an open state in which the outer door is spaced apart from the outer housing, and formed to accommodate a protective gas supplied at a second pressure that is set in relation to the first pressure; and
a fastening module including a support protrusion installed in the outer housing, a rotary member disposed to be rotatable with respect to the outer door, and an engaging protrusion extending from the rotary member and formed to be disposed on the support protrusion,
wherein the outer door includes an upper plate in contact with the outer housing in the closed state.

2. The high-pressure substrate processing apparatus of claim 1, wherein the engaging protrusion is disposed to be supported by the support protrusion as the engaging protrusion rotates in the closed state.

3. The high-pressure substrate processing apparatus of claim 1, wherein the rotary member is disposed below the upper plate.

4. The high-pressure substrate processing apparatus of claim 1, wherein the support protrusion is installed to protrude outward from the outer housing, and
the engaging protrusion is bent to surround the support protrusion.

5. The high-pressure substrate processing apparatus of claim 3, wherein the outer door further includes a lower plate disposed at a different level from the upper plate, and
the rotary member is disposed between the upper plate and the lower plate.

6. The high-pressure substrate processing apparatus of claim 5, wherein the outer door further includes a spacer disposed between the upper plate and the lower plate, and
the rotary member includes a rotary ring having a hollow portion formed to accommodate the spacer.

7. The high-pressure substrate processing apparatus of claim 1, wherein the outer door further includes a sealing member disposed between the upper plate and the outer housing in the closed state, and
the engaging protrusion is formed to rotate independently of contact between the upper plate, the sealing member, and the outer housing.

8. The high-pressure substrate processing apparatus of claim 1, wherein the fastening module further includes a drive unit configured to rotate the rotary member so as to rotate the engaging protrusion.

9. The high-pressure substrate processing apparatus of claim 8, wherein the drive unit includes:
a driven gear formed on the rotary member;
a drive gear meshing with the driven gear; and
a motor rotating the drive gear.

10. The high-pressure substrate processing apparatus of claim 1, wherein the outer door further includes a shaft protrusion protruding downward from the upper plate, and
the rotary member includes an accommodating groove that rotatably accommodates the shaft protrusion.

11. The high-pressure substrate processing apparatus of claim 10, wherein the rotary member includes:
a base portion having the accommodating groove formed therein; and
a protruding portion formed to protrude downward from the base portion,
the fastening module further includes a drive unit formed to rotate the rotary member, and
the drive unit includes:
a driven gear formed on an outer surface of the protruding portion;
a drive gear meshing with the driven gear; and
a motor rotating the drive gear.

12. A high-pressure substrate processing apparatus, comprising:
a chamber including a housing formed to accommodate a substrate to be processed and a process gas supplied at a pressure higher than atmospheric pressure, and a door formed to move between a closed state in which the housing is closed and an open state in which the housing is open; and
a fastening module including a support protrusion installed in the housing, a rotary member disposed to be rotatable with respect to the door, and an engaging protrusion extending from the rotary member and formed to be disposed on the support protrusion,
wherein the door includes an upper plate that contacts the housing in the closed state, and
the rotary member is disposed below the upper plate.

13. The high-pressure substrate processing apparatus of claim 12, wherein the engaging protrusion is disposed to be supported by the support protrusion as the engaging protrusion rotates in the closed state.

14. The high-pressure substrate processing apparatus of claim 12, wherein the engaging protrusion includes an engaging surface that faces the support protrusion and is disposed at a higher level than the door.

15. The high-pressure substrate processing apparatus of claim 12, wherein the process gas includes a reaction gas containing an active gas and a protective gas containing an inert gas, and
the housing includes:
an inner housing formed to accommodate the substrate to be processed and the reaction gas; and
an outer housing accommodating the inner housing and coupled to the inner housing to form a closed space that accommodates the protective gas together with the inner housing, and
the door is formed to close the inner housing.
